Europäisches Patentamt

(19) European Patent Office

Office européen des brevets

(11) Veröffentlichungsnummer: **0 045 321**
B1

(12) # EUROPÄISCHE PATENTSCHRIFT

(45) Veröffentlichungstag der Patentschrift:
10.12.86

(21) Anmeldenummer: 80104529.5

(22) Anmeldetag: 31.07.80

(51) Int. Cl.⁴: **G 01 D 5/26**, G 01 B 9/02, G 01 B 11/00, G 01 B 11/06

(54) Verfahren und Einrichtung zur optischen Distanzmessung.

(43) Veröffentlichungstag der Anmeldung:
10.02.82 Patentblatt 82/6

(45) Bekanntmachung des Hinweises auf die Patenterteilung:
10.12.86 Patentblatt 86/50

(84) Benannte Vertragsstaaten:
DE FR GB

(56) Entgegenhaltungen:
DE - A - 2 431 166
DE - B - 2 851 750
US - A - 4 167 337

OPTIK, Band 21, Nr. 11, November 1964, Seiten 574-579, Stuttgart, DE., H.J.M. LEBESQUE et al.: "Messung sehr kleiner Verschiebungen mit einem Polarisationsinterferometer"

(73) Patentinhaber: **International Business Machines Corporation, Old Orchard Road, Armonk, N.Y. 10504 (US)**
(84) Benannte Vertragsstaaten: **FR GB**

(73) Patentinhaber: **IBM DEUTSCHLAND GMBH, Pascalstrasse 100, D-7000 Stuttgart 80 (DE)**
(84) Benannte Vertragsstaaten: **DE**

(72) Erfinder: **Makosch, Günter, Stuttgarter Strasse 40, D-7032 Sindelfingen-Maichingen (DE)**

(74) Vertreter: **Teufel, Fritz, Dipl.-Phys., IBM Deutschland GmbH. Europäische Patentdienste Postfach 265, D-8000 München 22 (DE)**

## Beschreibung

Die Erfindung betrifft ein Verfahren zur optischen Distanzmessung nach dem Oberbegriff des Anspruchs 1 und Einrichtungen insbesondere zur Durchführung des Verfahrens nach dem Oberbegriff der Ansprüche 7, 9, 10, 11 und 12 (siehe DE-Al-2 431 166).

An die Messung von relativen oder absoluten Längen bzw. Verschiebungen werden in Wissenschaft und Technik immer höhere Genauigkeitsanforderungen gestellt. Ein Beispiel hierfür bietet die photolithographische Herstellung integrierter Schaltungen, bei der mittlerweile Strukturen mit einer Grössenordnung von 1 Mikrometer aufgelöst werden müssen. Zur genauen Positionierung der Halbleiterscheiben (Wafer) vor der Belichtung muss daher die relative Lage von bereits vorhandenen Strukturen und Belichtungsmaske auf Bruchteile eines Mikrometers genau einstellbar sein; um einen hohen Produktionsdurchsatz zu ermöglichen, muss diese Einstellung ausserdem sehr schnell erfolgen und darf an das Bedienungspersonal keine besonderen Anforderungen stellen.

Ähnliche Genauigkeitsanforderungen bestehen auch hinsichtlich der absoluten Messung von Längen, beispielsweise bei der Auswertung von Belichtungsmasken.

Die bisher hauptsächlich gebrauchten Messverfahren mit visueller Beobachtung sind im Submikronbereich nicht mehr verwendbar, da sie zu stark von der subjektiven Einschätzung durch den Bediener abhängen. Diese Einschränkung gilt auch für die interferometrischen Verfahren, die mit visueller Beobachtung arbeiten.

Eine Erhöhung der Genauigkeit kann mit photoelektrischer Signalauswertung erreicht werden. Als Messgrösse wird dabei die Lichtintensität verwendet, beispielsweise deren sinusförmige Variation in einem interferometrischen Messaufbau. Die bei der Auswertung dieses Kurvenverlaufes erreichbare Genauigkeit ist durch die starke Abhängigkeit der Lichtintensität von vielen Parametern des Messaufbaus begrenzt; in vielen Fällen kann daher nur eine Nullpunktbestimmung erfolgen und die gewünschte Messgrösse nur mit einer Genauigkeit bestimmt werden, die in der Grössenordnung der verwendeten Lichtwellenlänge liegt.

Derartige interferometrische Messsysteme sind beispielsweise so aufgebaut, dass die zu messende Länge Teil eines Michelson-Interferometeraufbaus bildet. Weitere interferometrische Verfahren, in denen die Phasenänderung von Licht ausgewertet wird, das an einem bewegten oder verschobenen optischen Gitter gebeugt wurde, sind in dem Artikel «A New Interferometric Alignment Technique» von D.C. Flenders und H.I. Smith in Applied Physics Letters, Band 31, Nr. 7 (Oktober 1977), Seite 426 und in der deutschen Offenlegungsschrift 2 431 166 beschrieben. Bei diesen Verfahren wird ebenfalls die Intensität der Interferenzerscheinungen ausgewertet, so dass sich die oben erwähnten Genauigkeitsbeschränkungen ergeben.

Die vorliegende Erfindung stellt sich daher die Aufgabe, ein Verfahren zur optischen Distanzmessung anzugeben, dessen Genauigkeit Bruchteile eines Mikrometers beträgt, das für eine Vielzahl von Messaufgaben einsetzbar ist, schnell durchgeführt werden kann und dessen Ergebnisse weitgehend unabhängig von der Bedienungsperson sind; ausserdem sollen Einrichtungen zur Durchführung des Verfahrens angegeben werden, die einen einfachen und stabilen Aufbau besitzen und an verschiedene Messaufgaben angepasst sind.

Diese Aufgabe wird durch die in den Ansprüchen 1, 7, 9, 10, 11 und 12 gekennzeichnete Erfindung gelöst; Ausgestaltungen der Erfindung sind in den abhängigen Ansprüchen gekennzeichnet.

Bei dem vorgeschlagenen Verfahren wird der Phasenunterschied zweier senkrecht zueinander polarisierter Teilbündel gemessen, der durch Wechselwirkung dieser Teilbündel mit gitterförmigen Strukturen auf dem Messobjekt hervorgerufen wird. Zur genauen Bestimmung der Relativlage zweier Objekte werden diese jeweils mit einem optischen Gitter versehen; die von diesen Gittern ausgehenden gebeugten und senkrecht zueinander polarisierten Teilstrahlen werden optisch zu einem Strahl vereinigt und die Phasendifferenz gemessen, aus der sich die laterale Verschiebung der beiden Objekte ergibt. Zur absoluten Bestimmung der Verschiebung eines Objekts wird die Phasenverschiebung zwischen verschiedenen Beugungsordnungen gemessen, die an einem mit dem Objekt verbundenen Gitter bei dessen Verschiebung entsteht.

Zur Durchführung des Verfahrens wird eine Einrichtung vorgeschlagen, die aus einem Grundinstrument mit austauschbaren Messköpfen besteht, die der jeweiligen Messaufgabe angepasst sind. Zur optischen Antastung des Messobjekts und zur optischen Rekombination der Teilstrahlen werden verschiedene Messköpfe mit doppelbrechenden Materialien angegeben. Die Signalauswertung erfolgt durch elektro-optische Kompensation des Phasenunterschieds in den wiedervereinigten Teilstrahlen in dem für alle Messköpfe gleich ausgebildeten Auswertesystem.

Die mit diesem Verfahren erreichbare hohe Genauigkeit beruht auf der Erzeugung senkrecht zueinander polarisierter Teilstrahlen (Beugungsordnungen), deren Phasenunterschied mit ausserordentlicher Genauigkeit durch elektro-optische Kompensation gemessen werden kann. Das Ausgangssignal der elektro-optischen Kompensationsvorrichtung stellt nämlich ein analoges Sägezahnsignal dar, das eine sehr gute Interpolation ermöglicht. Die gemeinsame Signalauswertung für verschiedene Messköpfe zur Antastung des Messobjektes stellt ein ausserordentlich vielfältiges und einfach zu bedienendes Messgerät dar.

Die erreichbare Messgenauigkeit liegt bei 0,02 µm oder in der Grössenordnung von 1/1000 der verwendeten Gitterkonstante; die Messzeit liegt in der Grössenordnung von Millisekunden und darunter.

Der optische Aufbau der Messköpfe und der Auswerteeinrichtung ist relativ einfach; Auflösungs- und Fokussierprobleme treten hier nicht auf.

Ausführungsbeispiele der Erfindung werden nun anhand von Zeichnungen näher erläutert. Es zeigen:

Fig. 1 eine schematische Darstellung des Messprinzips für relative Verschiebungen unter Verwendung zweier Gitter

Fig. 2A, 2B den schematischen Aufbau zweier Ausführungsformen der Messeinrichtung zur Durchführung des Messverfahrens nach Fig. 1

Fig. 3 das Ausgangssignal eines elektro-optischen Phasenkompensators nach Fig. 2

Fig. 4A, 4B, 4C den schematischen Aufbau von drei Ausführungsformen eines Messkopfs zur absoluten Bestimmung der lateralen Verschiebung eines Gitters

Fig. 5 die schematische Darstellung eines weiteren Messkopfs zur Messung lateraler Verschiebungen eines Gitters

Fig. 6 das Aufbauschema eines elektro-optischen Messgeräts mit auswechselbaren Messköpfen.

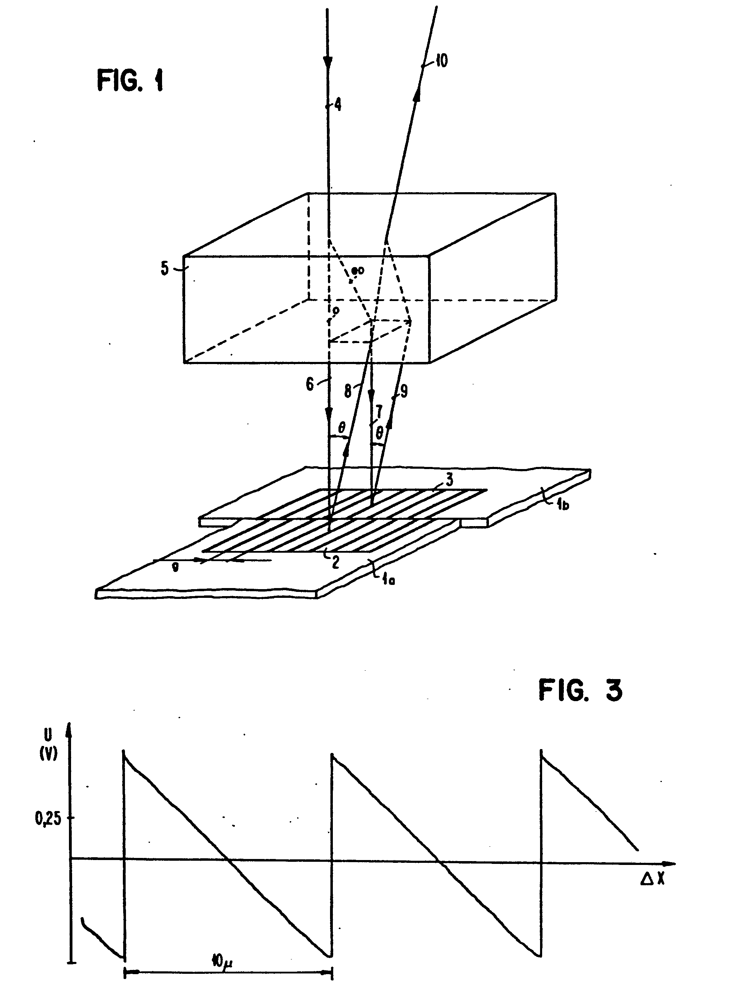

Fig. 1 zeigt das Prinzip eines Verfahrens zur elektro-optischen Messung der relativen Verschiebung zweier Objekte 1a, 1b gegeneinander. Auf jedem der Objekte ist eine als optisches Gitter wirkende Struktur 2, 3 mit einer Gitterkonstanten g aufgebracht, beispielsweise durch Drucken, Ritzen, Prägen usw. Bei idealer Ausrichtung der beiden Objekte weisen diese Gitter mit paralleler Gitterrichtung keine Versetzung gegeneinander auf.

Zur Beleuchtung der beiden Gitter 2, 3 mit zwei zueinander senkrecht polarisierten optischen Strahlenbündeln 6, 7 wird ein Lichtstrahl 4, z.B. ein Laserstrahl, auf einen optisch doppelbrechenden Kristall 5, z.B. Kalkspat, gerichtet und dort in zwei Teilstrahlen, einen ordentlichen (o) und einen ausserordentlichen (eo) aufgespalten. Beide Teilstrahlen verlassen den doppelbrechenden Kristall 5 als zueinander parallele Strahlenbündel 6, 7, deren Polarisationsrichtung senkrecht aufeinandersteht. Die Strahlenbündel 6, 7 überdecken mehrere Gitterperioden, werden an den beiden Gittern 2 bzw. 3 gebeugt und erzeugen mehrere Beugungsbündel verschiedener Ordnung; in Fig. 1 ist jeweils eine erste Beugungsordnung bei den Bezugszeichen 8 bzw. 9 eingezeichnet (die dargestellten Bezugswinkel sind nicht massstäblich).

Die an den Gittern gebeugten Strahlungsbündel 8, 9 gelangen wieder in den doppelbrechenden Kristall 5; durch die unterschiedliche Brechung von ordentlichem und ausserordentlichem Strahl werden die beiden reflektierten Bündel 8, 9 beim Austritt aus dem doppelbrechenden Kristall 5 wiedervereinigt und bilden ein gemeinsames Austrittsbündel 10 mit zwei senkrecht zueinander polarisierten Teilbündeln.

Die Auswahl der Beugungsordnung, die im Austrittsbündel 10 beobachtet werden soll, erfolgt durch die Wahl der Beobachtungsrichtung entsprechend dem Beugungswinkel θ.

$$\sin\theta_m = m\frac{\lambda}{g} \qquad m = 0, \pm1, \pm2 \text{ usw.} \quad (1)$$

$\lambda$ = Wellenlänge
$g$ = Gitterkonstante
$m$ = Beugungsordnung.

Aus Intensitätsgründen wird dabei die erste Beugungsordnung ($m = 1$) bevorzugt.

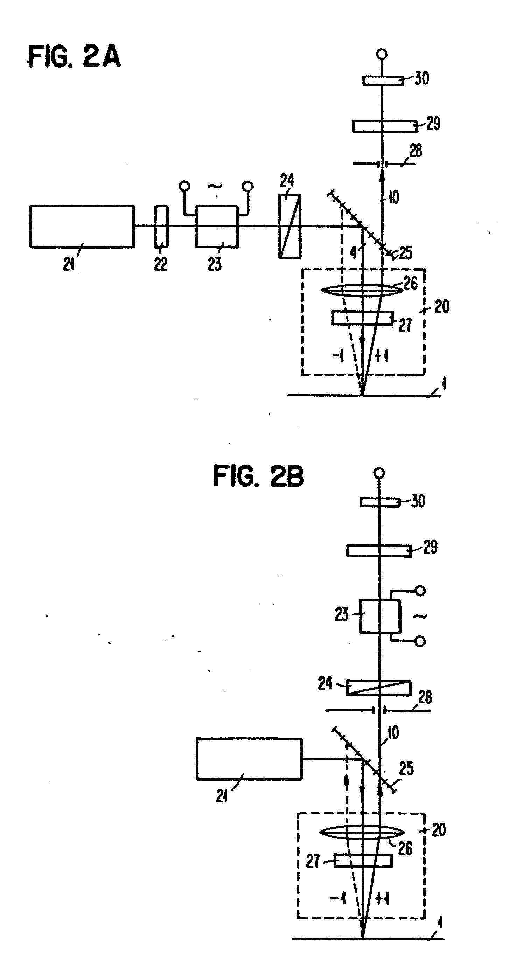

Bei idealer Ausrichtung und gleicher Höhe der beiden Objekte 1a, 1b tritt keine Phasendifferenz zwischen den beiden gebeugten Bündeln 8, 9 und damit auch keine Phasendifferenz im Austrittsbündel 10 auf. Eine Verschiebung der beiden Gitter gegeneinander bewirkt dagegen eine Phasendifferenz $\Phi_M$. Diese Phasendifferenz kann durch elektro-optische Kompensation sehr genau gemessen werden und stellt somit ein Mass für die fehlerhafte Ausrichtung der beiden Gegenstände 1a, 1b dar. Einzelheiten dieser Phasenmessung werden anhand von Fig. 2 beschrieben.

Das oben beschriebene Messprinzip kann auch angewendet werden, um die genaue Lagereproduzierbarkeit von aufeinanderfolgenden Herstellschritten zu überprüfen, beispielsweise bei der Herstellung von Halbleitern mit mehreren Maskenbelichtungsschritten. In diesem Fall wird in jedem der zu untersuchenden Prozessschritte eine Gitterstruktur 2 bzw. 3 auf ein einziges Halbleiterplättchen aufgebracht und die relative Lage dieser beiden Gitter nach dem oben beschriebenen Verfahren miteinander verglichen. Ein Versatz der Gitter (sogenannte Overlayfehler) kann dabei durch Justierfehler, Abbildungsfehler, Temperatureinflüsse bei der Herstellung usw. bedingt sein.

Fig. 2 zeigt den schematischen Aufbau eines Messgeräts zur Durchführung des anhand von Fig. 1 beschriebenen Messverfahrens; es besteht aus einem speziellen Messkopf 20, in dem die Strahlenaufteilung entsprechend Fig. 1 erfolgt, sowie aus Beleuchtungs- und Auswertevorrichtungen. Das Beleuchtungsbündel 4 wird von einem Laser 21 erzeugt, dem eine λ/2-Platte 22, ein elektro-optischer Lichtmodulator 23, ein Soleil-Babinet-Kompensator 24 und ein optischer Strahlteiler 25 nachgeschaltet sind. Mit der λ/2-Platte 22 wird die Polarisationsrichtung des Laserlichts gedreht; im elektro-optischen Lichtmodulator 23 wird das einfallende Licht in zwei senkrecht zueinander polarisierte Komponenten aufgespalten und durch Anlegen einer periodischen elektrischen Spannung eine periodische Phasenverschiebung zwischen diesen beiden Komponenten erzeugt. Im Soleil-Babinet-Kompensator 24 kann die Phasendifferenz zwischen den beiden polarisierten Teilbündeln auf einen festen Anfangswert eingestellt werden.

Zur Vermeidung von Depolarisierungseffekten bei der Reflexion am Strahlteiler 25 werden die den Modulator 23 verlassenden Teilbündel so orientiert, dass ihre Polarisationsrichtung parallel bzw. senkrecht zur Einfallsebene des Strahlteilers liegen. Die λ/2-Platte 22 ist entsprechend unter einem Winkel von 45° zu diesen beiden Polarisationsrichtungen zu orientieren.

Nach dem Eintritt in den Messkopf 20 wird das Laserbündel 4 auf die Oberfläche des Messobjekts 1 (bzw. die beiden aneinanderstossenden Objekte 1a, 1b gebündelt. Beim Durchgang des fokussierten Lichtbündels durch eine doppelbrechende Platte 27 erfolgt eine Aufspaltung in zwei zueinander parallele Lichtbündel 6, 7 entsprechend Fig. 1, deren gegenseitiger Abstand von der Kristalldicke bestimmt wird. Die Einzelheiten der Strahlführung nach Fig. 1 sind in Fig. 2 nicht dargestellt. Das eine Lichtbündel trifft dabei auf das eine Gitter, das andere Lichtbündel auf das andere. Die Linse 26 wird so angepasst, dass der Brennpunkt der Laserbündel auf dem Objekt etwa 10 Gitterperioden überdeckt. Das von den Gittern reflektierte und gebeugte Licht wird nach Rekombination durch den Kristall 27 in der Linse 26 kollimiert.

Für die Phasenmessung wird vorzugsweise die + 1. oder die –1. Beugungsordnung benutzt. Die Ausblendung der gewünschten Beugungsordnung erfolgt mit einer verschiebbaren Lochblende 28, die im Strahlengang hinter der teildurchlässigen Platte 25 angebracht ist. Das reflektierte Austrittsbündel 10 gelangt hinter der Lochblende 28 durch einen Polarisator 29 zu einem Photodetektor 30.

Die Einzelheiten der elektro-optischen Phasenkombination in einer Anordnung nach Fig. 2 sind in der deutschen Patentanmeldung P 2 851 750 beschrieben. Das Messprinzip lässt sich folgendermassen umreissen: Im elektro-optischen Modulator 23 wird das linear polarisierte Licht des Lasers 21 in zwei senkrecht zueinander polarisierte Teilstrahlen aufgespalten; abhängig vom Wert der am Modulator 23 anliegenden Spannung wird eine Komponente bezüglich der senkrecht dazu polarisierten Komponente verzögert. Die beiden senkrechten Teilbündel gelangen als ordentliche bzw. ausserordentliche Strahlen in den doppelbrechenden Kristall 27 und erfahren bei Reflexion an gitterähnlichen Strukturen auf dem Objekt 1 eine unterschiedliche Phasenverschiebung. Die beiden senkrecht zueinander polarisierten Teilstrahlen im Austrittsbündel 10 setzen sich somit je nach Grösse der relativen Phasenverschiebung zu linear, elliptisch oder zirkular polarisiertem Licht zusammen, so dass der bezüglich der linearen Polarisationsrichtung in Kreuzstellung angeordnete Analysator 29 kein, wenig oder viel Licht zum Detektor 30 gelangen lässt.

Bei Anlegen einer periodischen Spannung an den elektro-optischen Lichtmodulator 23 kann die Spannung bzw. die Phasendifferenz festgestellt werden, die erforderlich ist, um die Phasenverschiebung durch Reflexion an gegeneinander verschobenen Gitterstrukturen zu kompensieren. Der Nulldurchgang des Detektorsignals entspricht dieser kompensierenden Phasenverschiebung.

Die Phasenkompensation kann dabei sowohl auf der Beleuchtungsseite erfolgen als auch im Austrittsbündel. Fig. 2B zeigt eine gleichwertige Ausführungsform, in der der elektro-optische Lichtmodulator 23 und der Soleil-Babinet-Kompensator 24 zwischen Teilerplatte 25 und Analysator 29 geschaltet sind. Das Laserbündel 4 gelangt dabei direkt vom Laser 21 über Strahlteiler 25 in den Messkopf 20. In den Teilfiguren 2A, B tragen gleiche Komponenten gleiche Bezugszeichen.

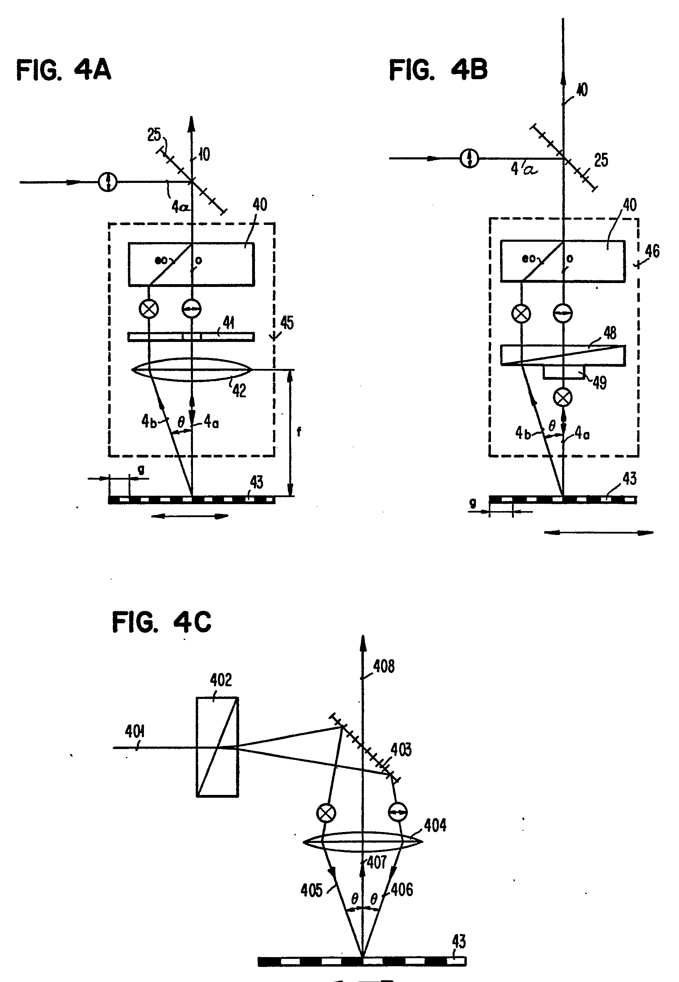

Das Ausgangssignal der elektro-optischen Kompensationsvorrichtung nach Fig. 2A, B ist in Fig. 3 dargestellt. Das Ausgangssignal (die Kompensationsspannung $u$, die linear mit der Phasendifferenz zusammenhängt) steigt linear mit der Verschiebung der beiden Gitter relativ zueinander, so dass sich eine Sägezahnkurve mit der Gitterperiode g (im Beispiel g = 10 μm) ergibt. Die Interpolation zwischen zwei Zwischenwerten ist bei dem linearen Verlauf dieser Spannung mit grosser Genauigkeit möglich.

Eine eindeutige Messung der Phasendifferenz $\Phi_m$ der beiden senkrecht zueinander polarisierten und an zueinander versetzten Gittern gebeugten Bündeln ist im Bereich

$$-\pi < \Phi_M < \pi \tag{2}$$

möglich. Das entspricht einer Verschiebung ΔX der beiden Gitter relativ zueinander um

$$-\frac{g}{2} < \Delta x < +\frac{g}{2}. \tag{3}$$

Allgemein ist der Zusammenhang zwischen der Phasenverschiebung $\Phi_M$ und der diese Phasenverschiebung bewirkenden Gitterverschiebung ΔX gegeben durch

$$\Delta X = \Phi_M \frac{g}{2\pi} \quad \text{wobei g = Gitterkonstante.} \tag{4}$$

Durch den linearen Verlauf des Ausgangssignals ist die Phasenauflösung α der oben besprochenen elektro-optischen Phasenmessmethode besser als

$$\alpha_\Phi = \frac{6}{1000}\pi.$$

Bei Verwendung eines Gitters mit einer Gitterkonstanten g = 6 μm ergibt sich eine Messauflösung für den Versatz der beiden Gitter von

$$\alpha_X = 0,02\ \mu m.$$

Der Messbereich beträgt dabei (ΔX) < 3 μm.

Zur Messung werden die beiden mit Gittern versehenen Objekte 1a, 1b (bzw. das Objekt 1 mit zwei aufgebrachten Gittern) zuerst so positioniert, dass beide aufgespaltenen Laserbündel zunächst auf das gleiche Gitter (z. B. Gitter 2) gerichtet sind. Bei dieser Stellung kann auch eine Phasendifferenz auftreten, beispielsweise durch Neigung der Objektoberfläche oder eine Verdrehung des Objekts. Diese Phasendifferenz wird gemessen und mit Hilfe des Babinet-Kompensators ein Phasenabgleich durchgeführt, so dass die resultierende Phasendifferenz 0 beträgt. Dann werden beide Teilbündel durch eine laterale Verschiebung oder durch Einführung einer geneigten parallelen Glasplatte auf jeweils eines der Gitter 2, 3 gerichtet. Die dann gemessene Phasendifferenz entspricht der Versetzung der beiden Gitter.

Bei dieser Messmethode wurde vorausgesetzt, dass zwischen beiden Gittern keine Höhendifferenz besteht. Im anderen Fall muss zuerst die Höhendifferenz bestimmt werden, da diese eine zusätzliche Phasendifferenz bedingt. Dazu können die direkt reflektierten Lichtbündel (nullte Beugungsordnungen) herangezogen werden, die durch entsprechende Verschiebung der Lochblende 28 auswählbar sind. In einem ersten Schritt werden beide Bündel 6, 7 auf dasselbe Gitter gerichtet und die Phasendifferenz auf null abgestimmt; die Höhendifferenz wird in einem zweiten Messschritt ermittelt, bei dem die Bündel 6, 7 auf verschiedene Gitter gerichtet werden.

Die bei Bewegung eines Gitters auftretende Phasenverschiebung zwischen verschiedenen Beugungsordnungen kann auch zur hochpräzisen, absoluten Längenmessung mit elektro-optischer Kompensation herangezogen werden. Der Phasenunterschied in zwei benachbarten Beugungsordnungen (z. B. der nullten und der ersten) ändert sich bei einer Verschiebung des Gitters relativ zum beleuchteten Laserstrahlbündel gemäss der oben für den Fall zweier Gitter erläuterten Gleichung (4). Die Bestimmung dieses Phasenunterschieds mit dem oben besprochenen Kompensationsverfahren führt zu einer Auflösung von besser als 1/1000 Gitterkonstante.

In den Fig. 4A, 4B sind zwei Ausführungsformen von Messköpfen 45 bzw. 46 dargestellt, mit denen ein Ausgangsstrahl 10 erzeugt werden kann, dessen beide senkrecht zueinander polarisierte Teilbündel eine elektro-optisch bestimmbare Phasendifferenz aufweisen. Zur Durchführung der Messung wird auf dem Objekt, dessen Verschiebung gemessen werden soll, oder auf dem Tisch, an dem das Objekt befestigt ist, ein winziger Gittermassstab 43 angebracht. Dieses Gitter, das aus praktischen Gründen eine Gitterkonstante $g$ von einigen $\mu m$ besitzen sollte, wird senkrecht mit einem linear polarisierten Laserbündel 4a beleuchtet; die reflektierten Lichtbündel in nullter Beugungsordnung ($m = 0$) und in erster Beugungsordnung ($m = 1$) werden durch doppelbrechende optische Bauelemente zu einem Ausgangsstrahl 10 vereinigt.

In Fig. 4A fällt das Beleuchtungsbündel 4a zuerst auf einen doppelbrechenden Kristall 40; die Polarisationsrichtung des Bündels 4a entspricht der des ordentlichen Strahls (o) im doppelbrechenden Kristall 40, so dass keine Strahlablenkung erfolgt. Der ordentliche Strahl gelangt dann durch eine Zentralöffnung in einem $\lambda/2$-Plättchen 41 und den Mittelpunkt einer Linse 42 zum Gitter 43, wo er gebeugt wird. Die Linse 42 ist ungefähr im Abstand ihrer Brennweite vom Gitter 43 entfernt angeordnet. Der Brennfleck überdeckt einige Gitterperioden. Das nichtgebeugte Licht (Beugungsordnung $m = 0$) wird senkrecht reflektiert und gelangt wiederum als ordentlicher Strahl in den doppelbrechenden Kristall 40. Das in erster Beugungsordnung gebeugte Licht 4b wird unter einem Winkel $\theta$ reflektiert, durch Linse 42 kollimiert und erfährt eine Drehung seiner Polarisationsebene um 90° im $\lambda/2$-Plättchen 41; es gelangt somit als ausserordentlicher Strahl in den doppelbrechenden Kristall 40, wird dort gebrochen und vereinigt sich am Ausgang des doppelbrechenden Kristalls 40 mit dem ordentlichen Strahl zum Ausgangsstrahl 10, der somit zwei senkrecht zueinander polarisierte Komponenten aufweist, die je nach Verschiebung des Gitters 43 eine mehr oder minder grosse relative Phasendifferenz aufweisen. Die Messung dieser Phasendifferenz durch elektro-optische Kompensation in einer Vorrichtung nach Fig. 2B ergibt wiederum das sägezahnförmige Ausgangssignal nach Fig. 3 (Die Auswertevorrichtung nach Fig. 2A kann hier nicht verwendet werden, da sonst das Eingangsbündel 4a zwei Polarisationsrichtungen aufweisen würde, die im doppelbrechenden Kristall aufgespalten würden). Die Dicke des doppelbrechenden Kristalls 40 wird entsprechend dem Beugungswinkel $\Phi$ so gewählt, dass an seiner Austrittsfläche die gewünschte Strahlrekombination auftritt.

Ein mit Fig. 4A gleich wirkender Messkopf 46 ist in Fig. 4B dargestellt; zwischen doppelbrechendem Kristall 40 und Gitter 43 ist dabei ein Rochon-Prisma 48 angebracht, sowie ein $\lambda/2$-Plättchen 49, das jedoch nur vom einfallenden und vom senkrecht reflektierten Licht durchsetzt wird. Der senkrecht zurückgeworfene Strahl nullter Ordnung gelangt nach der wiederholten Drehung seiner Polarisationsrichtung um 90° im $\lambda/2$-Plättchen 49 unabgelenkt durch das Rochon-Prisma und den doppelbrechenden Kristall 40. Die erste Beugungsordnung 4b dagegen, die mit der optischen Achse den Winkel $\theta$ einschliesst, behält ihre Polarisationsrichtung bei und durchsetzt das Rochon-Prisma 48 als ausserordentlicher Strahl. Der Ablenkwinkel des Rochon-Prismas wird dabei gleich dem Beugungswinkel $\theta$ gewählt, so dass der aus dem Rochon-Prisma austretende Strahl zur optischen Achse parallel ist und als ausserordentlicher Strahl in den doppelbrechenden Kristall 40 eintritt. Bei geeignet gewählter Dicke des Kristalls werden die beiden Strahlen den Kristall 40 als Ausgangsstrahl 10 verlassen und eine Phasendifferenz entsprechend der Verschiebung von Gitter 43 aufweisen.

Eine weitere Ausführungsform eines Messkopfs zur Messung lateraler Gitterverschiebungen ist in Fig. 4C dargestellt; er zeichnet sich durch eine erhöhte Empfindlichkeit aus.

Das Lichtbündel 401 eines Lasers fällt auf ein Wollaston-Prisma 402, wo es in zwei senkrecht zueinander polarisierte Teilstrahlen aufgespalten wird, die nach Reflektion an einem Strahlteiler 403 und Durchgang durch eine Linse 404 als Einfallsbündel 405 und 406 unter einem Einfallswinkel $\theta$ zusammen auf dem Messgitter 43 auftreffen. Der Winkel $\theta$ ist entsprechend der ersten Beugungsordnung gewählt, so dass die +1. und die −1. Beugungsordnung senkrecht zum Messgitter (in Richtung 407) abgebeugt werden.

Die aus den Bündeln 405, 406 entstehenden Beugungsordnungen bleiben weiterhin senkrecht zueinander polarisiert und weisen bei gleicher Gitterverschiebung einen Phasenunterschied auf, der dem doppelten des in Gleichung (4) angegebenen Werts entspricht (Gleichung (4) bezieht sich auf zwei benachbarte Beugungsordnungen). Das Ausgangsbündel 408 verlässt den Messkopf durch den Strahlteiler 403 und kann in üblicher Weise ausgewertet werden.

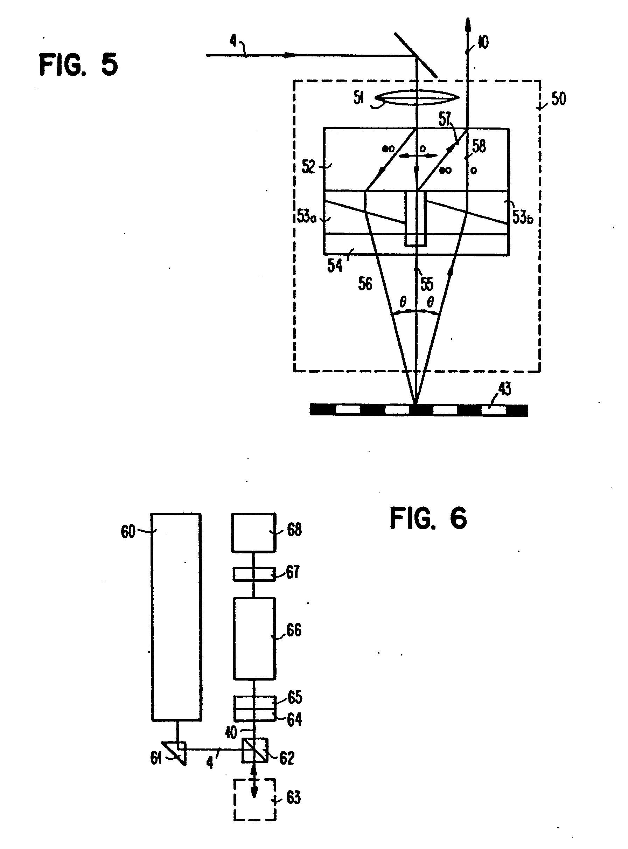

In den Ausführungsbeispielen nach Fig. 4 werden Mess- und Referenzstrahl durch den auf dem Gitter auftreffenden Laserstrahl am gleichen Ort des Gittermassstabs erzeugt. Dadurch ist dieses Messverfahren weitgehend unempfindlich gegen Brechungsindexänderungen durch Druck oder Temperaturschwankungen. Ausserdem ist das Verfahren unempfindlich gegenüber Abstandsschwankungen des Gittermassstabs relativ zum Messkopf. Die Messanordnungen nach Fig. 4 können auch zur Messung von Relativverschiebungen in der nach Fig. 1 beschriebenen Art verwendet werden; dazu wird der Messpunkt nacheinander auf die Gitter gerichtet und die relative Phasendifferenz für beide Stellungen ermittelt. Hierbei verfälschen geringe Höhendifferenzen der Gitter die Messergebnisse für die laterale Verschiebung nicht. Dieselben Vorteile bietet auch die im folgenden besprochene Messanordnung nach Fig. 5.

Ein weiteres Ausführungsbeispiel eines optischen Messkopfs 50 mit doppelbrechenden Elementen zur Messung lateraler Verschiebungen mit Hilfe einer am Messobjekt angebrachten gitterähnlichen Struktur ist in Fig. 5 dargestellt; er entspricht funktionsmässig den Messköpfen nach Fig. 4. Das zur Beleuchtung verwendete linear polarisierte Laserlichtbündel 4 tritt in den Messkopf 50 durch eine wahlweise vorhandene Linse 51 als ordentlicher Strahl 55 in einen doppelbrechenden Kristall 52 ein, den es unabgelenkt durchsetzt (der in Fig. 5 eingezeichnete ausserordentliche (eo) Eintrittsstrahl tritt bei dieser Betriebsweise nicht auf). Zwischen dem doppelbrechenden Kristall 52 und dem Messobjekt mit Gitter 43 sind ein Wollaston-Prisma 53a, 53b und ein 3λ/4-Plättchen 54 vorgesehen. Das Wollaston-Prisma enthält längs der optischen Achse eine Bohrung, in der der Mittelpunktsstrahl verläuft; das 3λ/4-Plättchen ist im selben Bereich der optischen Achse so ausgedünnt, dass es für den Mittelpunktsstrahl 55 als λ/4-Plättchen wirkt.

Der aus dem doppelbrechenden Kristall 52 austretende, ordentliche Mittelpunktsstrahl trifft senkrecht auf die Gitterstruktur 43 auf, und das direkt reflektierte Licht (in nullter Beugungsordnung) läuft als Mittelpunktsstrahl wieder zurück; beim zweimaligen Durchgang durch das λ/4-Plättchen in der Mitte der Platte 54 wird die Polarisationsebene des Lichtes nullter Beugungsordnung um 90° gedreht, so dass der reflektierte Strahlanteil im doppelbrechenden Kristall 52 als ausserordentlicher Strahl 57 verläuft und gebrochen wird.

Das Licht höherer Beugungsordnungen verlässt dagegen Gitter 43 unter einem Winkel θ entsprechend Gleichung (1) und gelangt über die 3λ/4-Platte 54 zum Wollaston-Prisma 53b. Der Ablenkwinkel dieses Wollaston-Prismas ist so gewählt, dass der Winkel θ gerade kompensiert wird und das Licht der gewählten höheren Beugungsordnung (vorzugsweise der ersten) als achsenparalleler Strahl in den doppelbrechenden Kristall 52 eintritt. Das gebeugte Licht hat auf dem Weg zum Gitter 43 das λ/4-Plättchen im Mittelpunktsteil der Platte 54 durchlaufen sowie nach seiner Reflektion den Teil der Platte 54, der einem 3λ/4-Plättchen entspricht; insgesamt hat dieses gebeugte Licht also ein λ-Plättchen durchlaufen, so dass keine resultierende Drehung der Polarisationsebene erfolgt ist und der Strahl 58 wieder als ordentlicher, nicht abgelenkter Strahl in die doppelbrechende Platte 52 eintritt; deren Dicke ist dabei so gewählt, dass an ihrem Ausgang die Strahlen 57 und 58 ein gemeinsames Ausgangsbündel 10 ergeben, in dem die beiden senkrecht zueinander polarisierten Teilstrahlen eine relative Phasendifferenz aufweisen, die der Verschiebung des Gitters 43 entspricht.

Der in Fig. 5 dargestellte Messkopf 50 lässt sich ausserdem ohne konstruktive Änderungen zur Durchführung eines Messverfahrens für vertikale Längenänderungen oder Stufenhöhen verwenden, wie es in der deutschen Patentanmeldung P 2 925 117.0 beschrieben ist. Dort wird das Messobjekt, dessen Oberflächenprofil bestimmt werden soll, mit zwei senkrecht zueinander polarisierten Teilbündeln beaufschlagt, deren Achsen einen Winkel miteinander einschliessen und die beide auf einem gemeinsamen Bereich der zu untersuchenden Oberfläche auftreffen; die reflektierten Strahlen werden dann zur Bildung von Interferenzen wiedervereinigt. In der erwähnten Patentanmeldung werden die beiden Teilstrahlen durch Aufspaltung in einem doppelbrechenden Kristall erzeugt und als Mittelpunkts- bzw. Randstrahlen durch eine Sammellinse auf das Untersuchungsobjekt fokussiert; der Winkel zwischen den beiden Teilstrahlen bestimmt sich aus der Strahlaufspaltung und der Brennweite der Sammellinse. Diese Einrichtung hat den Nachteil, dass das eine Teilbündel exakt als Mittelpunktsstrahl durch die Sammellinse geführt werden muss, da sonst kein exakt definierter Winkel gewährleistet ist.

Diese hohen Anforderungen an die Justiergenauigkeit werden bei dem Messkopf nach Fig. 5 vermieden, wenn als beleuchtende Teilstrahlen die Strahlen 55 und 56 verwendet werden, die bei der Aufspaltung eines Laserbündels 4 geeigneter Polarisationsrichtung im doppelbrechenden Kristall 52 auftreten. Der ordentliche Strahlenteil 55 wird wie im vorigen Beispiel als Mittelpunktsstrahl geführt, der ausserordentliche Anteil (eo) des Beleuchtungsbündels 4 wird in der doppelbrechenden Platte 52 abgelenkt, gelangt in das Wollaston-Prisma 53a, wo er erneut so abgelenkt wird, dass er auf der Oberfläche des Messobjekts mit dem Mittelpunktsstrahl 55 unter dem gewünschten Winkel θ zusammentrifft. Das Strahlenbündel 56 wird am Messpunkt, z.B. einer Stufe, nach dem Reflektionsgesetz reflektiert und im Wollaston-Prisma 53b wieder zu einem achsenparallelen Bündel abgelenkt. Das schräg auf dem Objekt 43 auftreffende Bündel durchläuft vor und nach der Reflektion jeweils den Teil der Platte 54, deren Dicke einem 3λ/4-Plättchen entspricht, so dass insgesamt eine Drehung der Polarisationsebene um 90° erfolgt; der Strahl 58 verläuft also in der doppelbrechenden Platte 52 als ordentlicher Strahl und rekombiniert mit dem senkrecht reflektierten Mittelpunktsstrahl 55, der beim zweimaligen Durchgang durch die $\lambda$/4-Platte im Mittelpunktsbereich der Platte 54 eine Drehung der Polarisationsebene um 90° erfuhr und deshalb nach der Reflexion als ausserordentlicher Strahl 57 in der doppelbrechenden Platte 52 verläuft.

Bei der Anordnung nach Fig. 5 wird der Winkel $\theta$ zwischen den beiden Strahlen 55 und 56 nur durch die Kenngrössen der doppelbrechenden Elemente 52, 53 bestimmt, die mechanisch fest miteinander verbunden sind (beispielsweise verkittet). Damit treten die oben erwähnten Justierschwierigkeiten oder Änderungen des Winkels während der Messung nicht mehr auf.

Für die bisher beschriebenen Messköpfe 20, 45, 46, 50 kann zur Auswertung der zwischen den beiden polarisierten Teilstrahlen erzeugten Phasendifferenz ein einziges elektro-optisches Messgerät verwendet werden. Fig. 6 zeigt den schematischen Aufbau eines derartigen universellen, modularen elektro-optischen Messgeräts.

Das Ausgangsbündel 4 eines Lasers 60 wird über einen Umlenkspiegel 61 auf einen Strahlteiler (z.B. Würfel 62) gegeben und gelangt dann in den jeweiligen Messkopf, der in eine gemeinsam benutzbare Halterung 63 eingesetzt ist. Das auf die Phasendifferenz zu analysierende Ausgangsbündel 10 tritt durch eine Lochblende 64 in einen Babinet-Soleil-Kompensator 65 und gelangt von dort in einen elektro-optischen Modulator 66, einen Analysator 67 und einen Detektor 68. Soll in dieses Messgerät ein Messkopf nach Fig. 4C eingesetzt werden, muss der Strahlteiler 62 abgenommen werden.

Die Anzahl der mit dem Messgerät nach Fig. 6 verwendbaren Messköpfe ist nicht auf die hier erwähnten beschränkt; es kann eine Vielzahl weiterer Messköpfe angeschlossen werden, wie sie beispielsweise in den deutschen Patentanmeldungen P 2 851 750.2 und der obenerwähnten P 2 925 117.0 beschrieben sind; wichtig ist nur, dass in dem jeweiligen Messkopf jeweils zwei zueinander senkrecht polarisierte Teilstrahlen erzeugt werden, die eine vom Messvorgang beeinflusste Phasendifferenz aufweisen. Damit stellt die Messeinrichtung nach Fig. 6 ein ausserordentlich vielseitiges Instrumentarium für einen sehr grossen Bereich hochgenauer optischer Messungen zur Verfügung, beispielsweise Längenmessungen relativer oder absoluter Art, Oberflächenuntersuchungen wie Stufen, Krümmungen, Steigungen, Kantenuntersuchungen usw. Bedingt durch die grosse Geschwindigkeit des Kompensationsverfahrens ergibt sich eine hohe Messgeschwindigkeit; das Verfahren kann auch vollautomatisch durchgeführt werden.

Zur Erhöhung der Messauflösung können anstelle der bisher erwähnten niedrigen Beugungsordnungen auch höhere Ordnungen herangezogen werden.

Die hier vorgeschlagenen Verfahren und Einrichtungen eignen sich auch zur genauen Ausmessung zweidimensionaler Muster, von Interferenz- und Moiréstreifen.

Die in der Beschreibung verwendeten Ausdrükke «Strahlen», «Teilstrahlen» sind der Kürze halber anstelle der genaueren Bezeichnungen «Strahlenbündel» und «Teilstrahlenbündel» gebraucht.

**Patentansprüche**

1. Verfahren zur optischen Distanzmessung, bei dem ein Eingangsstrahlenbündel (4 ; 4a; 7; 55; 405) an einem verschiebbaren optischen Messgitter (3; 43) gebeugt wird, um ein Messstrahlenbündel (9; 4b; 58) zu erzeugen, dessen Phase durch Überlagerung mit einem Referenzstrahlenbündel (4a; 8; 57) ermittelt wird, dadurch gekennzeichnet, dass das Referenzstrahlenbündel (4a; 8; 57) kollinear und senkrecht polarisiert zum Messstrahlenbündel (9; 4b; 58) eingerichtet wird und dass die bei Verschiebung des Messgitters (3; 43) hervorgerufene Phasendifferenz zwischen dem Mess- und dem Referenzstrahlenbündel durch elektro-optische Phasenkompensation bestimmt wird.

2. Verfahren nach Anspruch 1, dadurch gekennzeichnet, dass das Referenzstrahlenbündel im wesentlichen längs des gleichen optischen Wegs geführt wird wie das Messstrahlenbündel.

3. Verfahren nach Anspruch 1 oder 2, dadurch gekennzeichnet, dass zur Erzeugung des Referenzstrahlenbündels (8) ein ortsfestes zweites optisches Gitter (2) vorgesehen ist, an dem ein zum Eingangsstrahlenbündel (7) paralleles und senkrecht dazu polarisiertes Strahlenbündel (6) gebeugt und unter dem gleichen Beugungswinkel ($\theta$) abgenommen wird, unter dem das Messstrahlenbündel am Messgitter (3) entsteht.

4. Verfahren nach Anspruch 1 oder 2, dadurch gekennzeichnet, dass das Referenzstrahlenbündel am Messgitter aus einer Beugungsordnung des Eingangsstrahlenbündels erzeugt wird, die sich von der Beugungsordnung des Messstrahlenbündels unterscheidet.

5. Verfahren nach Anspruch 4, dadurch gekennzeichnet, dass das Messgitter (43) mit einem polarisierten Eingangsstrahlenbündel (4a) beleuchtet wird und dass die Polarisationsrichtung des Messstrahlenbündels (4b) um 90° gedreht wird.

6. Verfahren nach Anspruch 4, dadurch gekennzeichnet, dass ein zweites Eingangsstrahlenbündel (406) vorgesehen ist, das senkrecht zum ersten Eingangsstrahlenbündel (405) polarisiert ist und symmetrisch dazu mit gleichem Einfallswinkel ($\theta$) auf das Messgitter (43) auftrifft und dass das Messstrahlenbündel und das Referenzstrahlenbündel (407) kollineare Beugungsordnungen der Eingangsstrahlenbündel darstellen.

7. Einrichtung zur optischen Distanzmessung mit Vorrichtungen, die ein Eingangsstrahlenbündel (4; 4a; 7; 55; 405) auf ein verschiebbares optisches Messgitter (3; 43) richten, an dem durch Beugung ein Messstrahlenbündel (4b; 9; 58) entsteht und mit Vorrichtungen zur Bestimmung der Phase des Messstrahlenbündels durch Überlagerung mit einem Referenzstrahlenbündel (4a; 8; 57), insbesondere zur Durchführung des Verfahrens nach Anspruch 3, dadurch gekennzeichnet, dass eine doppelbrechende Platte (5; 27) vorgesehen ist, die ein Eingangsstrahlenbündel (4) in zwei gegeneinander versetzte parallele Strahlenbündel (6; 7) aufspaltet, auf das Messgitter bzw. ein zweites ortsfestes Gitter (2) richtet und jeweils gleiche von den Gittern ausgehende Beugungsordnungen kollinear in einem Ausgangsstrahlenbündel (10) rekombiniert und dass die bei Verschiebung des Messgitters hervorgerufene Phasendifferenz zwischen dem Mess- und dem Referenzstrahlenbündel durch Vorrichtungen (23; 29; 30) zur elektro-optischen Phasenkompensation bestimmt wird.

8. Einrichtung nach Anspruch 7, dadurch gekennzeichnet, dass vor der doppelbrechenden Platte (27) eine Sammellinse (26) zur Fokussierung der Eingangsstrahlenbündel (4) auf die Messgitter (43) vorgesehen ist.

9. Einrichtung zur optischen Distanzmessung mit Vorrichtungen, die ein Eingangsstrahlenbündel (4; 4a; 7; 55; 405) auf ein verschiebbares optisches Messgitter (3; 43) richten, an dem durch Beugung ein Messstrahlenbündel (4b; 9; 58) entsteht und mit Vorrichtungen zur Bestimmung der Phase des Messstrahlenbündels durch Überlagerung mit einem Referenzstrahlenbündel (4a; 8; 57), insbesondere zur Durchführung des Verfahrens nach Anspruch 5, dadurch gekennzeichnet, dass im optischen Weg vor dem Messgitter (43) eine doppelbrechende Platte (40), ein λ/2-Plättchen (41) mit einem Zentralloch und eine Linse (42) angeordnet sind und der Abstand der Linse vom Messgitter ihrer Brennweite entspricht, dass das Eingangsstrahlenbündel (4) in der optischen Achse verläuft, dass das reflektierte Beugungsbündel erster Ordnung nach Drehung seiner Polarisationsrichtung im λ/2-Plättchen von der doppelbrechenden Platte mit dem Beugungsbündel nullter Ordnung rekombiniert wird und dass die bei Verschiebung des Messgitters hervorgerufene Phasendifferenz zwischen dem Mess- und dem Referenzstrahlenbündel durch Vorrichtungen (23; 29; 30) zur elektro-optischen Phasenkompensation bestimmt wird.

10. Einrichtung zur optischen Distanzmessung mit Vorrichtungen, die ein Eingangsstrahlenbündel (4; 4a; 7; 55; 405) auf ein verschiebbares optisches Messgitter (3; 43) richten, an dem durch Beugung ein Messstrahlenbündel (4b; 9; 58) entsteht und mit Vorrichtungen zur Bestimmung der Phase des Messstrahlenbündels durch Überlagerung mit einem Referenzstrahlenbündel (4a; 8; 57), insbesondere zur Durchführung des Verfahrens nach Anspruch 5, dadurch gekennzeichnet, dass im optischen Pfad des Eingangsstrahlenbündels (4) vor dem Messgitter (43) eine doppelbrechende Platte (40), ein Rochon-Prisma (48) und ein λ/2-Plättchen (49) angeordnet sind, dass das in erster Ordnung am Messgitter gebeugte Messstrahlenbündel vor seinem Eintritt in die doppelbrechende Platte (40) das Rochon-Prisma (48) durchläuft und zu einem achsenparallelen Bündel gebrochen wird, das durch die doppelbrechende Platte (40) mit dem reflektierten Beugungsbündel nullter Ordnung rekombiniert wird und dass die bei Verschiebung des Messgitters hervorgerufene Phasendifferenz zwischen dem Mess- und dem Referenzstrahlenbündel durch Vorrichtungen (23; 29; 30) zur elektro-optischen Phasenkompensation bestimmt wird.

11. Einrichtung zur optischen Distanzmessung mit Vorrichtungen, die ein Eingangsstrahlenbündel (4; 4a; 7; 55; 405) auf ein verschiebbares optisches Messgitter (3; 43) richten, an dem durch Beugung ein Messstrahlenbündel (4b; 9; 58) entsteht und mit Vorrichtungen zur Bestimmung der Phase des Messstrahlenbündels durch Überlagerung mit einem Referenzstrahlenbündel (4a; 8; 57), insbesondere zur Durchführung des Verfahrens nach Anspruch 6, dadurch gekennzeichnet, dass im optischen Weg des Eingangsstrahlenbündels (401) ein Wollaston-Prisma (402) und eine Sammellinse (404) angeordnet sind, um zwei symmetrisch zum Messgitter (43) einfallende Eingangsstrahlenbündel zu erzeugen, wobei der Einfallswinkel (θ) dem Beugungswinkel erster Ordnung entspricht und als kollineare Ausgangsstrahlenbündel (408) die +/1. und die −/1. Beugungsordnung dienen und dass die bei Verschiebung des Messgitters hervorgerufene Phasendifferenz zwischen dem Mess- und dem Referenzstrahlenbündel durch Vorrichtungen (23; 29; 30) zur elektro-optischen Phasenkompensation bestimmt wird.

12. Einrichtung zur optischen Distanzmessung mit Vorrichtungen, die ein Eingangsstrahlenbündel (4; 4a; 7; 55; 405) auf ein verschiebbares optisches Messgitter (3; 43) richten, an dem durch Beugung ein Messstrahlenbündel (4b; 9; 58) entsteht und mit Vorrichtungen zur Bestimmung der Phase des Messstrahlenbündels durch Überlagerung mit einem Referenzstrahlenbündel (4a; 8; 57), insbesondere zur Durchführung des Verfahrens nach Anspruch 4, dadurch gekennzeichnet, dass im optischen Weg des Eingangsstrahlenbündels (4) längs der optischen Achse eine doppelbrechende Platte (52), ein Wollaston-Prisma (53) mit Zentralloch und ein 3λ/2-Plättchen 54 mit ausgedünntem, einem λ/2-Plättchen entsprechenden Zentralteil angeordnet ist, dass der Ablenkwinkel des Wollaston-Prismas (53) dem Beugungswinkel (θ) erster Ordnung entspricht, dass die am Messgitter reflektierte nullte Beugungsordnung mit der ersten Beugungsordnung von der doppelbrechenden Platte (52) in ein kollineares Ausgangsstrahlenbündel (10) rekombiniert werden und dass die bei Verschiebung des Messgitters hervorgerufene Phasendifferenz zwischen dem Mess- und dem Referenzstrahlenbündel durch Vorrichtungen (23; 29; 30) zur elektro-optischen Phasenkompensation bestimmt wird.

13. Einrichtung nach Anspruch 12, dadurch gekennzeichnet, dass vor der doppelbrechenden Platte (52) eine Sammellinse (51) angeordnet ist.

14. Einrichtung nach Anspruch 12 oder 13, dadurch gekennzeichnet, dass die Polarisation des Eingangsstrahlenbündels (4) der Polarisation des ordentlichen Strahls in der doppelbrechenden Platte (52) entspricht.

15. Einrichtung nach Anspruch 12 oder 13, dadurch gekennzeichnet, dass die Polarisation des Eingangsstrahlenbündels (4) so gewählt ist, dass in der doppelbrechenden Platte (52) ein ordentlicher (o) und ein ausserordentlicher (eo) Strahl entstehen.

16. Einrichtung nach einem der Ansprüche 7 bis 15, dadurch gekennzeichnet, dass im Strahlengang des Ausgangsstrahlenbündels hintereinander angeordnet sind: ein Babinet-Soleil-Kompensator (64), ein elektro-optischer Modulator (66), ein Analysator (67) und ein Photodetektor (68).

17. Einrichtung nach einem der Ansprüche 7, 8 oder 15, dadurch gekennzeichnet, dass im Strahlengang des Eingangsstrahlenbündels eine λ/2-Platte (22), ein elektro-optischer Modulator (23) und ein Babinet-Soleil-Kompensator (64) hintereinander angeordnet sind und dass im Strahlengang des Ausgangsstrahlenbündels ein Analysator (67) und ein Photodetektor (68) angeordnet sind.

18. Einrichtung nach Anspruch 16, dadurch gekennzeichnet, dass die Vorrichtungen zur Erzeugung des Eingangsstrahlenbündels einen Laser (60) umfassen, dessen Achse parallel zur optischen Achse des Ausgangsstrahlenbündels (10) angeordnet ist und dass Strahlenumlenkvorrichtungen (61; 62) vorgesehen sind, um das Eingangsstrahlenbündel auf das senkrecht zur Achse des Ausgangsstrahlenbündels liegende Messgitter zu richten.

## Claims

1. Method for optical distance measurement, wherein an entry beam (4; 4a; 7; 55; 405) is diffracted at a displaceable optical measuring grating (3; 43) for generating a measuring beam (9; 4b; 58) whose phase is determined by superimposition with a reference beam (4a; 8; 57), characterized in that the reference beam (4a; 8; 57) is collinear with and polarized perpendicularly to the measuring beam (9; 4b; 58), and that the phase difference between the measuring and the reference beam occurring during the displacement of the measuring grating (3; 43) is determined by electrooptical phase compensation.

2. Method according to claim 1, characterized in that the reference beam is guided substantially along the same optical path as the measuring beam.

3. Method according to claim 1 or 2, characterized in that for generating the reference beam (8), a stationary second optical grating (2) is provided at which a beam (6) parallel to and polarized perpendicularly to the entry beam (7) is diffracted and picked up at the same diffraction angle (θ) at which the measuring beam at the measuring grating (3) is generated.

4. Method according to claim 1 or 2, characterized in that the reference beam at the measuring grating is generated from a diffraction order of the entry beam which differs from the diffraction order of the measuring beam.

5. Method according to claim 4, characterized in that the measuring grating (43) is alluminated with a polarized entry beam (4a), and that the direction of polarization of the measuring beam (4b) is rotated by 90°.

6. Method according to claim 4, characterized in that a second entry beam (406) is provided which is polarized perpendicularly to the first entry beam (405) and which symmetrically thereto is incident at the same angle of incidence (θ) on the measuring grating (43), and that the measuring beam and the reference beam (407) are collinear diffraction orders of the entry beam.

7. Arrangement for optical distance measurement, comprising means directing an entry beam (4; 4a; 7; 55; 405) onto a displaceable optical measuring grating (3; 43) at which a measuring beam (4b; 9; 58) is generated by diffraction, and means for determining the phase of the measuring beam by superimposition with a reference beam (4a; 8; 57), in particular for implementing the method according to claim 3, characterized in that a birefringent plate (5; 27) is provided splitting an entry beam (4) into two parallel beams (6; 7) staggered relative to each other, directing them onto the measuring grating and a second stationary grating (2), respectively, and collinearly recombining in an exit beam (10) identical diffraction orders emanating from the gratings, and that the phase difference between the measuring and the reference beam occurring during the displacement of the measuring grating is determined by means (23; 29; 30) for electrooptical phase compensation.

8. Arrangement according to claim 7, characterized in that in front of the birefringent plate (27) a collector lens (26) is provided for focusing the entry beam (4) onto the measuring gratings (43).

9. Arrangement for optical distance measurement comprising means directing an entry beam (4; 4a; 7; 55; 405) onto a displaceable optical measuring grating (3; 43) at which a measuring beam (4b; 9; 58) is generated by diffraction, and means for determining the phase of the measuring beam by superimposition with a reference beam (4a; 8; 57), in particular for implementing the method according to claim 5, characterized in that in the optical path in front of the measuring grating (43) a birefringent plate (40), a λ/2 plate (41) with a center hole and a lens (42) are positioned and the distance of the lens from the measuring grating corresponds to its focal length, that the entry beam (4) extends in the optical axis, that the reflected diffracted beam of the first order after rotation of its direction of polarization in the λ/2 plate is recombined by the birefringent plate with the diffracted beam of the zeroth order, and that the phase difference between the measuring and the reference beam occurring upon displacement of the measuring grating is determined by means (23; 29; 30) for electrooptical phase compensation.

10. Arrangement for optical distance measurement comprising means directing an entry beam (4; 4a; 7; 55; 405) onto a displaceable optical measuring grating (3; 43) at which a measuring beam (4b; 9; 58) is generated by diffraction, and means for determining the phase of the measuring beam by superimposition with a reference beam (4a; 8; 57), in particular for implementing the method according to claim 5, characterized in that in the optical path of the entry beam (4) in front of the measuring grating (43) a birefringent plate (40), a Rochon prism (48) and a λ/2 plate (49) are positioned, that the measuring beam diffracted in its first order at the measuring grating, prior to entering the birefringent plate (40), passes the Rochon prism (48), being diffracted to form a paraxial beam which by the birefringent plate (40) is recombined with the reflected diffracted beam of the zeroth order, and that the phase difference between the measuring and the reference beam occurring during the displacement of the measuring grating is determined by means (23; 29; 30) for electrooptical phase compensation.

11. Arrangement for optical distance measurement comprising means directing an entry beam (4; 4a; 7; 55; 405) onto a displaceable optical measuring grating (3; 43) at which a measuring beam (4b; 9; 58) is generated by diffraction, and means for determining the phase of the measuring beam by superimposition with a reference beam (4a; 8; 57), in particular for implementing the method according to claim 6, characterized in that in the optical path of the entry beam (401) a Wollaston prism (402) and a collector lens (404) are positioned for generating two entry beams symmetrically incident to the measuring grating (43), the angle of incidence (θ) corresponding to the diffraction angle of the first order, and the +1th and the −1th diffraction order serving as collinear exit beams, and that the phase difference between the measuring beam and the reference beam occurring during the displacement of the measuring grating is determined by means (23; 29; 30) for electrooptical phase compensation.

12. Arrangement for optical distance measurement comprising means directing an entry beam (4; 4a; 7; 55; 405) onto a displaceable optical measuring grating (3; 43) at which a measuring beam (4b; 9; 58) is generated by diffraction, and means for determining the phase of the measuring beam by superimposition with a reference beam, in particular for implementing the method according to claim 4, characterized in that in the optical path of the entry beam (4) along the optical axis a birefringent plate (52), a Wollaston prism (53) with a center hole and a 3λ/2 plate (54) with a thinned out center portion corresponding to a λ/2 plate are provided, that the deflection angle of the Wollaston prism (53) corresponds to the diffraction angle (θ) of the first order, that the zeroth diffraction order reflected at the measuring grating is recombined by the birefringent plate (52) with the first diffraction order to form a collinear exit beam (10), and that the phase difference between the measuring and the reference beam occurring during the displacement of the measuring grating is determined by means (23; 29; 30) for electrooptical phase compensation.

13. Arrangement according to claim 12, characterized in that in front of the birefringent plate (52) a collector lens (51) is positioned.

14. Arrangement according to claim 12 or 13, characterized in that the polarization of the entry beam (4) corresponds to the polarization of the ordinary (o) beam in the birefringent plate (52).

15. Arrangement according to claim 12 or 13, characterized in that the polarization of the entry beam (4) is chosen such that an ordinary (o) and an extraordinary (eo) beam are produced in the birefringent plate (52).

16. Arrangement according to any one of the claims 7 to 15, characterized in that in the path of the exit beam the following means are arranged in tandem: a Babinet Soleil compensator (64), an electrooptical modulator (66), an analyzer (67), and a photodetector (68).

17. Arrangement according to any one of the claims 7, 8 or 15, characterized in that in the path of the entry beam a λ/2 plate (22), an electrooptical modulator (23) and a Babinet Soleil compensator (64) are arranged in tandem, and that in the path of the exit beam an analyzer (67) and a photodetector (68) are positioned.

18. Arrangement according to claim 16, characterized in that the means for generating the entry beam comprise a laser (60) whose axis is arranged parallel to the optical axis of the exit beam (10), and that beam deflectors (61; 62) are provided for directing the entry beam onto the measuring grating positioned perpendicularly to the axis of the exit beam.

**Revendications**

1. Procédé de mesure optique des distances dans lequel on diffracte un faisceau de rayons d'entrée (4; 4a; 7; 55; 405) sur un réseau de mesure optique déplaçable (3; 43) pour produire un faisceau de rayons de mesure (9; 4b; 58) dont on détermine la phase par superposition avec un faisceau de rayons de référence (4a; 8; 57), caractérisé par le fait que l'on ajuste le faisceau de rayons de référence (4a; 8; 57) polarisé colinéairement et perpendiculairement au faisceau de rayons de mesure (9; 4b; 58) et que par compensation de phase électro-optique on détermine la différence de phase provoquée entre le faisceau de rayons de mesure et le faisceau de rayons de référence par le déplacement du réseau de mesure (3; 43).

2. Procédé selon la revendication 1, caractérisé par le fait que l'on fait passer le faisceau de rayons de référence sensiblement le long du même trajet optique que le faisceau de rayons de mesure.

3. Procédé selon la revendication 1 ou 2, caractérisé par le fait que pour la production du faisceau de rayons de référence (8), on prévoit un second réseau optique fixe (2) sur lequel un faisceau de rayons (6), parallèle au faisceau de rayons d'entrée (7) et polarisé perpendiculaires à celui-ci, est diffracté et renvoyé sous le même angle de diffraction (θ) que celui sous lequel le faisceau de rayons de mesure est formé sur le réseau de mesure (3).

4. Procédé selon la revendication 1 ou 2, caractérisé par le fait que l'on produit le faisceau de rayons de référence sur le réseau de mesure à partir d'un ordre de diffraction du faisceau de rayons d'entrée qui diffère de l'ordre de diffraction du faisceau de rayons de mesure.

5. Procédé selon la revendication 4, caractérisé par le fait qu'on éclaire le réseau de mesure (43) avec un faisceau de rayons d'entrée polarisé (4a) et qu'on tourne de 90° le sens de polarisation du faisceau de rayons de mesure (4b).

6. Procédé selon la revendication 4, caractérisé par le fait qu'on prévoit un second faisceau de rayons d'entrée (406) qui est polarisé perpendiculairement au premier faisceau de rayons d'entrée (405) et qui arrive symétriquement à celui-ci avec même angle d'incidence (θ) sur le réseau de mesure (43), et que le faisceau de rayons de mesure et le faisceau de rayons de référence (407) représentent des ordres de diffraction colinéaires des faisceaux de rayons d'entrée.

7. Dispositif de mesure optique des distances comprenanr des appareils qui dirigent un faisceau de rayons d'entrée (4; 4a; 7; 55; 405) sur un réseau de mesure optique déplaçable (3; 43) sur lequel un faisceau de rayons de mesure (4b; 9; 58) est produit par diffraction, ainsi que des appareils pour la détermination de la phase du faisceau de rayons de mesure par superposition avec un faisceau de rayons de référence (4a; 8; 57), en particulier pour la mise en œuvre du procédé selon la revendication 3, caractérisé par le fait qu'il est prévu une plaque biréfringente (5; 27) qui scinde un faisceau de rayons d'entrée (4) en deux faisceaux de rayons parallèles (6; 7) décalés l'un par rapport à l'autre, qui les dirigent sur le réseau de mesure et un second réseau fixe (2) et recombinent respectivement les mêmes ordres de diffraction partant des réseaux colinéairement en un faisceau de rayons de sortie (10) et que la différence de phase provoquée entre le faisceau de rayons de mesure et le faisceau de rayons de référence par le déplacement du réseau de mesure est déterminée par des appareils (23; 29; 30) de compensation de phase électro-optique.

8. Dispositif selon la revendication 7, caractérisé par le fait qu'en amont de la plaque biréfringente (27) est prévue une lentille convergente (26) pour la focalisation des faisceaux de rayons d'entrée (4) sur le réseau de mesure (43).

9. Dispositif de mesure optique des distances comprenant des appareils qui dirigent un faisceau de rayons d'entrée (4; 4a; 7; 55; 405) sur un réseau de mesure optique déplaçable (3; 43) sur lequel un faisceau de rayons de mesure (4b; 9; 58) est produit par diffraction, ainsi que des appareils pour la détermination de la phase du faisceau de rayons de mesure par superposition avec un faisceau de rayons de référence (4a; 8; 57), en particulier pour la mise en œuvre du procédé selon la revendication 5, caractérisé par le fait que dans le trajet optique, en amont du réseau de mesure (43), sont disposées une plaque biréfringente (40), une plaquette λ/2 (41) munie d'un trou central et une lentille (42) et que la distance de la lentille par rapport au réseau de mesure correspond à sa distance focale, que le faisceau de rayons d'entrée (4) passe dans l'axe optique, que le faisceau de diffraction réfléchi de premier ordre après rotation de son sens de polarisation dans la plaquette λ/2 est recombiné par la plaque biréfringente au faisceau de diffraction d'ordre zéro et que la différence de phase provoquée entre le faisceau de rayons de mesure et le faisceau de rayons de référence par le déplacement du réseau de mesure est déterminée par des appareils (23; 29; 30) de compensation de phase électro-optique.

10. Dispositif de mesure optique des appareils qui dirigent un faisceau de rayons d'entrée (4; 4a; 7; 55; 405) sur un réseau de mesure optique déplaçable (3; 43) sur lequel un faisceau de rayons de mesure (4b; 9; 58) est produit par diffraction, ainsi que des appareils pour la détermination de la phase du faisceau de rayons de mesure par superposition avec un faisceau de rayons de référence (4a; 8; 57), en particulier pour la mise en œuvre du procédé selon la revendication 5, caractérisé par le fait que dans le trajet optique du faisceau de rayons d'entrée (4) en amont du réseau de mesure (43) sont disposées une plaque biréfringente (40), un prisme Rochon (48) et une plaquette λ/2 (49), que le faisceau de rayons de mesure diffracté dans le premier ordre sur le réseau de mesure traverse le prisme Rochon (48) avant son entrée dans la plaque biréfringente (40) et est réfracté en un réseau parallèle à l'axe qui est recombiné par la plaque biréfringente (40) au faisceau de diffraction réfléchie d'ordre zéro, et que la différence de phase provoquée entre le faisceau de rayons de mesure et le faisceau de rayons de référence par le déplacement du réseau de mesure est déterminée par des dispositifs (23; 29; 30) de compensation de phase électro-optique.

11. Dispositif de mesure optique des distances comprenant des appareils qui dirigent un faisceau de rayons d'entrée (4; 4a; 7; 55; 405) sur un réseau de mesure optique déplaçable (3; 43) sur lequel un faisceau de rayons de mesure (4b; 9; 58) est produit par diffraction, ainsi que des appareils pour la détermination de la phase du faisceau de rayons de mesure par superposition avec un faisceau de rayons de référence (4a; 8; 57), en particulier pour la mise en œuvre du procédé selon la revendication 6, caractérisé par le fait que dans le trajet optique du faisceau de rayons d'entrée (401) sont disposés un prisme de Wollaston (402) et une lentille convergente (404) pour produire deux faisceaux de rayons d'entrée arrivant symétriquement par rapport au réseau de mesure (43), l'angle d'incidence (θ) correspondant à l'angle de diffraction de premier ordre et les premiers ordres de diffraction +1 et −1 servant de faisceaux de rayons de sortie colinéaires (408) et que la différence de phase provoquée entre le faisceau de rayons de mesure et le faisceau de rayons de référence par le déplacement du réseau de mesure est déterminée par des dispositifs (23; 29; 30) de compensation de phase électro-optique.

12. Dispositif de mesure optique des distances comprenant des appareils qui dirigent un faisceau de rayons d'entrée (4; 4a; 7; 55; 405) sur un réseau de mesure optique déplaçable (3; 43) sur lequel un faisceau de rayons de mesure (4b; 9; 58) est produit par diffraction, ainsi que des appareils pour la détermination de la phase du faisceau de rayons de mesure par superposition avec un faisceau de rayons de référence (4a; 8; 57), en particulier pour la mise en œuvre du procédé selon la revendication 4, caractérisé par le fait que dans le trajet optique du faisceau de rayons d'entrée (4), le long de l'axe optique sont disposés une plaque biréfringente (52), un prisme de Wollaston (53) avec trou central et une plaquette 3λ/2 (54) avec partie centrale amincie correspondant à une plaquette λ/2, que l'angle de déviation du prisme de Wollaston (53) correspond à l'angle de diffraction (θ) de premier ordre, que l'ordre de diffraction zéro réfléchi sur le réseau de mesure est recombiné au premier ordre de diffraction par la plaque biréfringente (52) en un faisceau de rayons de sortie colinéaires (10) et que la différence de phase provoquée entre le faisceau de rayons de mesure et le faisceau de rayons de référence par le déplacement du réseau de mesure est déterminée par des dispositifs (23; 29; 30) de compensation de phase électro-optique.

13. Disposition selon la revendication 12, caractérisé par le fait qu'une lentille convergente (51) est placée en amont de la plaque biréfringente (52).

14. Dispositif selon la revendication 12 ou 13, caractérisé par le fait que la polarisation du faisceau de rayons d'entrée (4) correspond à la polarisation du rayon ordinaire dans la plaque biréfringente (52).

15. Dispositif selon la revendication 12 ou 13, caractérisé par le fait que la polarisation du faisceau de rayons d'entrée (4) est choisie de manière que dans la plaque biréfringente (52) il se forme un rayon ordinaire (o) et un rayon extraordinaire (eo).

16. Dispositif selon l'une des revendications 7 à 15, caractérisé par le fait que dans le trajet des rayons du faisceau de rayons de sortie sont disposés les uns derrière les autres: un compensateur Babinet-Soleil (64), un modulateur électro-optique (66), un analyseur (67) et un photodétecteur (68).

17. Dispositif selon l'une des revendications 7, 8 ou 15, caractérisé par le fait que dans le trajet des rayons du faisceau de rayons d'entrée, une plaque λ/2 (22), un modulateur électro-optique (23) et un compensateur Babinet-Soleil (64) sont montés les uns derrière les autres, et que dans le trajet des rayons du faisceau de rayons de sortie sont disposés un analyseur (67) et un photodétecteur (68).

18. Dispositif selon la revendication 16, caractérisé par le fait que les appareils pour la production du faisceau de rayons d'entrée comportent un laser (60) dont l'axe est disposé parallèlement à l'axe optique du faisceau des rayons de sortie (10), et qu'il est prévu des appareils de déviation des rayons (61; 62) pour diriger le faisceau de rayons d'entrée sur le réseau de mesure disposé perpendiculairement à l'axe du faisceau de rayons de sortie.

0 045 321

FIG. 1

FIG. 3

13

# FIG. 2A

# FIG. 2B

# FIG. 4A

# FIG. 4B

# FIG. 4C

**FIG. 5**

**FIG. 6**